# EUROPEAN PATENT APPLICATION

(11) **EP 4 471 854 A1**
(43) Date of publication of application: **04.12.2024**
(21) Application number: 24178427.1
(22) Date of filing: 28.05.2024
(51) Int. Cl.: H01L 23/495, H01L 23/498, H01L 23/373, H01L 25/07, H01L 23/00

(54) **POWER MODULE PACKAGE AND MANUFACTURE METHOD THEREOF**

(30) Priority: 29.05.2023 CN 202310616071
(71) Applicant: Nexperia B.V., 6534 AB Nijmegen (NL); Nexperia Technology (Shanghai) Ltd., Shanghai 200025 (CN)
(72) Inventor: Poelma, Regnerus Hermannus, Nijmegen (NL); Cui, Song, Shanghai (CN); Zhuang, Zhaorong, Shanghai (CN); Qian, Qiuxiao, Shanghai (CN)
(74) Representative: Pjanovic, Ilija

(57) **Abstract**

The present invention provides a power module package and manufacture method thereof. The power module package includes: a substrate, a first trace and a second trace insulated from each other on the substrate, and at least one semiconductor die. Each semiconductor die includes a first electrode pad, a second electrode pad and a control electrode pad. The first electrode pad and the control electrode pad are on a first surface of the semiconductor die facing the substrate, and the second electrode pad is on a second surface of the semiconductor die facing away from the substrate. The first electrode pad is connected to the first trace, and the control electrode pad is connected to the second trace. The power module package further includes a first electrode contact directly connected to the first trace, a second electrode contact directly connected to the second electrode pad of each semiconductor die from a side of the at least one semiconductor die away from the substrate, and a control electrode contact directly connected to the second trace.

## Description

### Technical Field

The present invention is related to a power module package and a method of manufacturing the power module package.

### BACKGROUND OF THE INVENTION

Wide bandgap semiconductor (WBG) devices such as SiC and GaN provide high dielectric strength, high operating temperature, high current density, high switching speed, and low on-resistance, and therefore significantly improve performance, miniaturization, and efficiency. A power module for WBG semiconductors needs to be carefully designed to remove heat, provide secure high voltage insulation against the heat sink, conduct high current, and should have electro-magnetically and thermo-mechanically reliability. However, existing package module designs for SiC switches rely on many combinations of different interconnection technologies, such as (1) wire bonds, (2) die-attachment based on sintering, (3) die clip bonds based on soldering, and (4) leadframe to substrate solder connections.

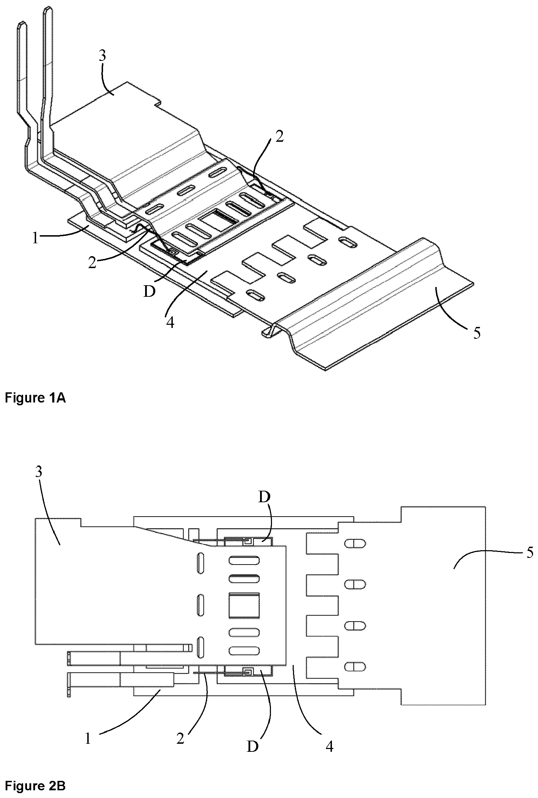

FIGS. 1A and 1B show an example of an existing power module. In FIGS. 1A and 1B, two SiC semiconductor dies D (e.g., power MOSFET) are attached to a substrate 1, with a source pad and a gate pad of each die D located on a side of the die D facing away from the substrate 1. As shown in FIGS. 1A and 1B, the gate pad of each semiconductor die D is bonded to a corresponding contact by a long wire 2, the source pad of each semiconductor die D and a source lead frame 3 are clip-bonded, a drain pad of each semiconductor die D faces the substrate 1 and is attached to a metal layer 4 on the substrate, and the metal layer 4 is in turn connected to a drain lead frame 5.

Having multiple interconnect technologies and multiple dies inside a module increases the manufacturing complexity and introduces extra challenges regarding process control, which can affect yield and final product quality. For example, the tool clearance of the wire bonder and assembly accuracy of the source clip result in relatively small source clip connections that result in increased thermal and electrical package resistance. Moreover, the high power, high switching frequency and fast switching speed of WBG semiconductors (e.g., SiC and GaN) would affect the parasitic inductance of power terminals and the overall module stray inductances invoked in long planar wire bond connections. Particularly, the wire bonds limit the fast-switching performance of a SiC or GaN power module. Finally, additional failure modes are introduced when wire bonding is combined with clip bonding.

### SUMMARY OF THE INVENTION

In one aspect, the present invention provides a power module package, including: a substrate, a first trace and a second trace on the substrate, the first trace and the second trace being insulated from each other, at least one semiconductor die, each of the at least one semiconductor die including a first electrode pad, a second electrode pad, and a control electrode pad, wherein the first electrode pad and the control electrode pad are on a first surface of the semiconductor die, the first surface facing the substrate, the second electrode pad is on a second surface of the semiconductor die, the second surface facing away from the substrate, the first electrode pad is connected to the first trace, and the control electrode pad is connected to the second trace, a first electrode contact directly connected to the first trace, a second electrode contact directly connected to the second electrode pad of each semiconductor die from a side of the at least one semiconductor die away from the substrate, and a control electrode contact directly connected to the second trace.

According to an embodiment of the present invention, the power module package further includes a Kelvin probe directly connected to the first electrode contact.

According an embodiment of the present invention, the power module package has a die mounting area, and the power module package includes a metal layer on the substrate within the die mounting area, the die mounting area includes a central area, a control electrode connection area, a first peripheral area surrounding the central area and a second peripheral area surrounding the control electrode connection area, the metal layer within the control electrode connection area is insulated from the metal layer within the central area, the metal layer within the central area and the metal layer within the first peripheral area are connected and have different heights, and the metal layer within the control electrode connection area and the metal layer within the second peripheral area are connected and have different heights.

According to an embodiment of the present invention, the first electrode pad is attached to the metal layer within the central area by a metallic particle sintering method, and the second electrode contact is attached to the second electrode pad by a metallic particle sintering method.

According to an embodiment of the present invention, the first trace, the second trace and the metal layer are formed from a same layer of metal, and the first trace and the second trace have a same height as the metal layer within the central area.

According to an embodiment of the present invention, the substrate has a plurality of die mounting areas, the second trace includes a first portion and a second portion parallel to each other and a third portion connecting the first portion and the second portion, the first portion and the second portion are disposed on opposite sides of the plurality of die mounting areas and connected to the control electrode pads of the dies in the die mounting areas, the first trace is disposed within an area surrounded by the second trace and connected to the first electrode pads of the dies in the plurality of die mounting areas.

According to an embodiment of the present invention, the plurality of die mounting areas includes a first group of die mounting areas and a second group of die mounting areas, the first group of die mounting areas and the second group of die mounting areas are arranged symmetrically, and the first trace extends between the first group of die mounting areas and the second group of die mounting areas.

According to an embodiment of the present invention, the power module package further includes a lead frame including a main body portion and two second contacts extending from the main body portion, wherein the second electrode pads of the semiconductor dies disposed in the first group of die mounting areas are directly connected to one of the two second contacts, and the second electrode pads of the semiconductor dies disposed in the second group of die mounting areas are directly connected to the other of the two second contacts.

According to an embodiment of the present invention, the main body portion includes a stress relief structure.

According to an embodiment of the present invention, an entire surface of the second electrode pad is directly connected to the second electrode contact.

According to an embodiment of the present invention, the first electrode contact and the second electrode contact extend toward two opposite directions, respectively.

According to an embodiment of the present invention, the control electrode pad includes gold stud bump or copper stud bump.

According to an embodiment of the present invention, the power module package is directly connected to an actively cooled heat sink.

According to an embodiment of the present invention, the first electrode pad is a source pad, the second electrode pad is a drain pad, and the control electrode pad is a gate pad.

According to an embodiment of the present invention, the first electrode pad is an emitter pad, the second electrode pad is a collector pad, and the control electrode pad is a gate pad.

In a further aspect, the present invention provides a method of manufacturing a power module package, including: forming a first trace and a second trace insulated from each other on a substrate, attaching at least one semiconductor die to the substrate, wherein each of the at least one semiconductor die includes a first electrode pad, a second electrode pad and a control electrode pad, the first electrode pad and the control electrode pad are on a first surface of the semiconductor die, the second electrode pad is on a second surface of the semiconductor die opposite to the first surface, and the attaching includes: causing the first surface of each semiconductor die to face the substrate, and connecting the first electrode pad to the first trace, and connecting the control electrode pad to the second trace, directly connecting a first electrode contact to the first trace, directly connecting a second electrode contact to the second electrode pad of each semiconductor die, and directly connecting a control electrode contact to the second trace.

According to an embodiment of the present invention, the power module package has a die mounting area including a central area, a control electrode connection area, a first peripheral area surrounding the central area, and a second peripheral area surrounding the control electrode connection area, and the method further includes: forming a metal layer within the die mounting area, such that the metal layer within the control electrode connection area is insulated from the metal layer within the central area, the metal layer within the central area and the metal layer within the first peripheral area are connected and have different heights, the metal layer within the control electrode connection area and the metal layer within the second peripheral area are connected and have different heights, the metal layer within the first peripheral area is connected to the first trace, and the metal layer within the second peripheral area is connected to the second trace.

According to an embodiment of the present invention, the attaching further includes: aligning the control electrode pad with the control electrode connection area, and aligning the first electrode pad with the central area, and attaching the control electrode pad to the metal layer within the control electrode connection area, while attaching the first electrode pad to the metal layer within the central area.

According to an embodiment of the present invention, the aligning and attaching are implemented by a flip chip bonder with high precision visual alignment.

According to an embodiment of the present invention, the first electrode pad is attached to the metal layer within the central area, the first electrode contact is attached to the first trace, and the second electrode contact is attached to the second electrode pad by a metallic particle sintering method.

According to an embodiment of the present invention, the method further includes: forming a Kelvin probe directly connected to the first electrode contact.

According to an embodiment of the present invention, the first trace, the second trace and the metal layer are formed by etching a same metal material layer on the substrate, and the first trace and the second trace have a same height as the metal layer within the central area.

According to an embodiment of the present invention, the power module package is formed to have a plurality of die mounting areas, the second trace is formed to include a first portion and a second portion parallel to each other, and a third portion connecting the first portion and the second portion, the first portion and the second portion are formed on opposite sides of the plurality of die mounting areas and directly connected to the control electrode pads of the dies in the die mounting areas, and the first trace is formed within an area surrounded by the second trace and directly connected to the first electrode pads of the dies in the plurality of die mounting areas.

According to an embodiment of the present invention, the plurality of die mounting areas includes a first group of die mounting areas and a second group of die mounting areas, the first group of die mounting areas and the second group of die mounting areas are arranged symmetrically, and the first trace extends between the first group of die mounting areas and the second group of die mounting areas.

According to an embodiment of the present invention, the method further includes: providing a lead frame including a main body portion and two second contacts extending from the main body portion, and connecting one of the two second contacts to the second electrode pads of the dies in the first group of die mounting areas, and connecting the other of the two second contacts to the second electrode pads of the dies in the second group of die mounting areas.

According to an embodiment of the present invention, an entire surface of the second electrode pad is directly connected to the second electrode contact.

According to an embodiment of the present invention, the first electrode contact and the second electrode contact extend toward two opposite directions, respectively.

According to an embodiment of the present invention, the control electrode pad is formed to include gold stud bump or copper stud bump.

According to an embodiment of the present invention, the first electrode pad is a source pad, the second electrode pad is a drain pad, and the control electrode pad is a gate pad.

According to an embodiment of the present invention, the first electrode pad is an emitter pad, the second electrode pad is a collector pad, and the control electrode pad is a gate pad.

### BRIEF DESCRIPTION OF DRAWINGS

FIGS. 1A and 1B show an example of an existing power module.
FIG. 2 is a schematic diagram of a power module package according to an embodiment of the present invention.
FIGS. 3A and 3B are schematic diagrams respectively illustrating the front side and the backside of a semiconductor die in the embodiment of FIG. 2.
FIG. 4 is a schematic diagram of a gate pad of a semiconductor die including a studbump.
FIG. 5 is a schematic diagram of a substrate formed with a metal layer in a power module package in the embodiment of FIG. 2.
FIG. 6 is a schematic diagram illustrating that a semiconductor die, a source contact and a gate contact are attached to the substrate of FIG. 5.
FIG. 7 is a top view of the power module package of FIG. 2.
FIG. 8 is a side view of the power module package of FIG. 2.
FIG. 9 is a schematic diagram of a power module package including a drain contact and a drain lead frame separated from each other.
FIG. 10 is a top view of a power module package including a drain contact and a drain lead frame separated from each other.
FIG. 11 is a side view of a power module package including a drain contact and a drain lead frame separated from each other.
FIG. 12 is a comparison diagram of a power module package according to the present invention and a source up power module package of the prior art.
FIG. 13 shows a finite element steady state thermal simulation of a source up configuration versus a source down configuration.
FIG. 14 shows a finite element simulation for the thermal impedance calculation of the SiC junction temperature towards the backside of the heat sink.
FIG. 15 shows another finite element simulation for the thermal impedance calculation of the SiC junction temperature towards the backside of the heat sink.
FIG. 16 shows a finite element simulation of DC electrical performance.
FIG. 17 is a flow chart of a method of manufacturing a power module package according to the present invention.
FIG. 18 is a side view after completion of the encapsulation.
FIG. 19 is a perspective view from above after completion of the encapsulation.
FIG. 20 is a perspective view from below after completion of the encapsulation.
FIG. 21 is a side view of two interconnected packages.
FIG. 22 is a schematic diagram of four interconnected packages.

### DETAILED DESCRIPTION OF THE INVENTION

For a person skilled in the art to better understand the inventions of this application, as non-limiting examples, the semiconductor device provided by the present invention will be described in detail below in conjunction with the accompanying drawings.

It should also be noted that for the purpose of describing these exemplary embodiments herein, the views will show general features of the methods and devices of the exemplary embodiments of the present invention. These views, however, are not drawn to scale and may not precisely reflect the features of any given embodiment, and should not be understood as defining or limiting the range of values or characteristics of the exemplary embodiments within the scope of the present invention.

The terms such as "having", "including", "including" and "containing" are openended, these terms indicate the existence of stated structures, elements or features, but do not preclude the existence of additional elements or features. The articles "a," "an" or "the" are intended to mean both plural and singular, except where the context explicitly indicates otherwise.

The inventions of this application provide a power module package, including: a substrate, a first trace and a second trace on the substrate, and at least one semiconductor die attached to the substrate. The first trace and the second trace are insulated from each other. Each of the at least one semiconductor die includes a first electrode pad, a second electrode pad and a control electrode pad, the first electrode pad and the control electrode pad are on a first surface of the semiconductor die, the first surface faces the substrate. The second electrode pad is on a second surface of the semiconductor die, the second surface faces away from the substrate. The first electrode pad is connected to the first trace, and the control electrode pad is connected to the second trace. The power module package further includes: a first electrode contact directly connected to the first trace, a second electrode contact directly connected to the second electrode pad of each semiconductor die from a side of the at least one semiconductor die away from the substrate, and a control electrode contact directly connected to the second trace.

The inventions of this application provide a new power module package design, which has source down die-attach and drain clip-attach interconnect on a substrate with low ohmic resistance, and a Kelvin probe with high mechanical and vibrational robustness. The source down connection and drain clip-attach cause low ohmic resistance, improve EMI robustness, and reduce manufacturing complexity because no wire bonds are used to connect. By reducing the ohmic resistance, less heat is generated and a longer product lifetime could be realized. More specifically, according to the power module package of this application, the first electrode pad and the control electrode pad face the substrate and are connected to the corresponding contacts via the first trace and the second trace on the substrate, respectively, and the second electrode pad faces away from the substrate and is directly connected to the corresponding contact. In this way, no wire bonds are used to connect, eliminating wires does not only reduce the on-resistance (Rdson) of the module, but also improves switching performance and efficiency, and reduces thermal impedance. By eliminating wires and top metallic resistance, a smaller SiC die with lower input capacitance and gate charge may be used to achieve the same product performance. With source down, the gate drive losses of the present invention are lower than the wire-bonded counterpart device. Eliminating wires could also reduce parasitic package inductance.

In addition, the second electrode pad is separately located on a surface of the semiconductor die at one side and has a larger area, thereby enabling large area connection with the corresponding contact, and hence improving thermal impedance.

In the present invention, two elements "directly connected" means that there are no intermediate elements between these two elements.

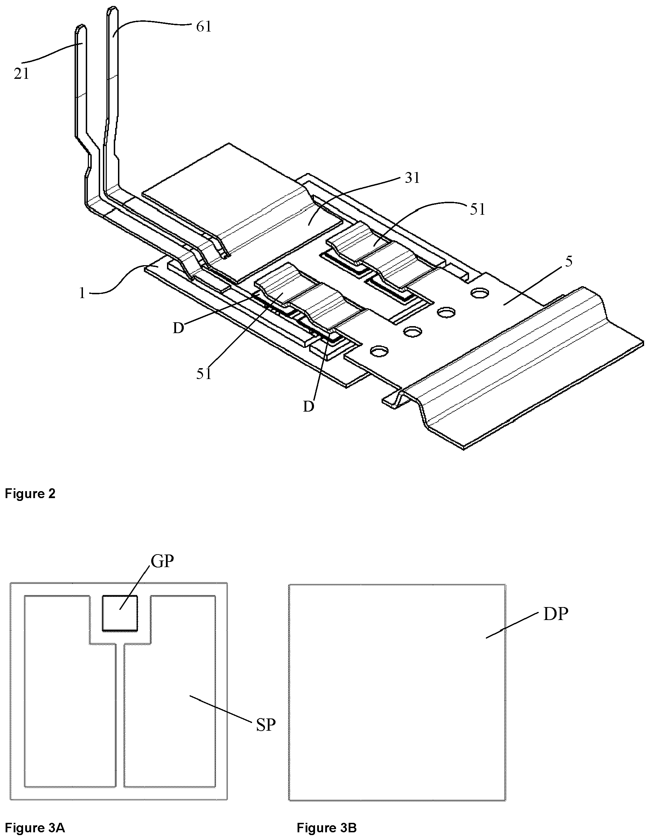

FIG. 2 is a schematic diagram of a power module package according to an embodiment of the present invention. As shown in FIG. 2, the power module package includes a substrate 1 and a plurality of semiconductor dies D attached to the substrate 1.

Each semiconductor die D includes a first electrode pad, a second electrode pad and a control electrode pad, and is configured to control the resistance of a path between the first electrode pad and the second electrode pad based on a control signal at the control electrode pad. In an embodiment, the semiconductor die is a MOSFET, the first electrode pad is a source pad, the second electrode pad is a drain pad, and the control electrode pad is a gate pad. In another embodiment, the semiconductor die is an IGBT, the first electrode pad is an emitter pad, the second electrode pad is a collector pad, and the control electrode pad is a gate pad. The following embodiments are described when the semiconductor die is a MOSFET.

FIGS. 3A and 3B are schematic diagrams illustrating the front side and backside of a semiconductor die, respectively. As shown in FIG. 3A, the front side of the semiconductor die D includes a source pad SP and a gate pad GP isolated from each other, and the backside of the semiconductor die D includes a drain pad DP. In some embodiments, the drain pad DP covers the entire backside of the semiconductor die D. The structure of FIG. 3 can be applied to an IGBT. In the case of an IGBT, the front side of the semiconductor die includes an emitter pad and a gate pad isolated from each other, and the backside of the semiconductor die includes a collector pad.

In an embodiment of the present invention, the substrate may include a DCB (Direct Copper Bond) substrate or an AMB (Active Metal Brazing) substrate. The AMB substrate has good thermal performance and excellent reliability.

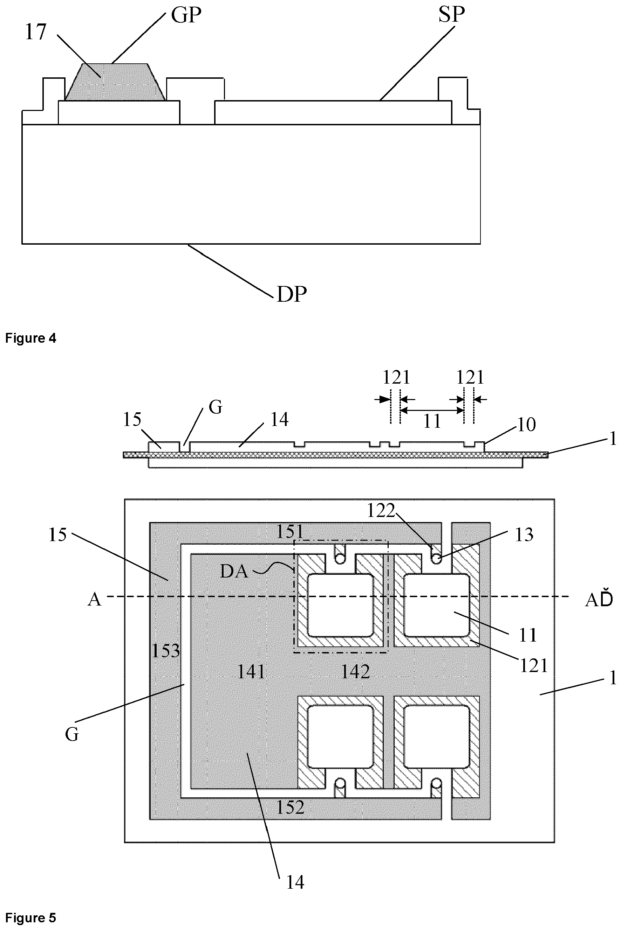

In some embodiments of this application, as shown in FIG. 4, the gate pad of the semiconductor die may include gold stud bump or copper stud bump (Au/Cu stud bump) 17, which could increase the thickness of the interconnect material (metal sintering or solder) between the die and the substrate (i.e., BLT, Bond line thickness) and robustness of the bonding between the die and the substrate.

FIG. 5 is a schematic diagram of a substrate formed with a metal layer in the power module package of FIG. 1. The upper part of FIG. 5 is a cross-sectional view taken along AA' in the lower part of FIG. 5. As shown in FIG. 5, the power module package has a die mounting area DA including a central area 11, a control electrode connection area 13, a first peripheral area 121 surrounding the central area 11, and a second peripheral area 122 surrounding the control electrode connection area 13. A metal layer 10 is formed on the substrate 1, a portion of the metal layer 10 within the control electrode connection area 13 is insulated from a portion of the metal layer within the central area 11, the portion of the metal layer 10 within the central area 11 and a portion of the metal layer 10 within the first peripheral area 121 are connected and have different heights, and the portion of the metal layer 10 within the control electrode connection area 13 and a portion of the metal layer 10 within the second peripheral area 122 are connected and have different heights. In this way, it is possible to form die edge features in the first peripheral area 121 and the second peripheral area 122 of the die mounting area, and to form gate-source clearance between the portion of the metal layer within the control electrode connection area 13 and the portion of the metal layer within the central area 11, which could help to improve the positioning accuracy during attachment of the semiconductor die to the substrate. The die edge features and the gate-source clearance can be realized by various means, either by subtractive (half-etching or milling) or additive (plating, stud-bumped or printing) means.

It should be noted that "the height of the metal layer" herein refers to a distance from a surface of the metal layer away from the substrate to a surface of the substrate formed with the metal layer.

In some embodiments of this application, a height of the portion of the metal layer within the central area 11 is greater than a height of the portion of the metal layer within the first peripheral area 121, and a height of the portion of the metal layer within the control electrode connection area 13 is greater than a height of the portion of the metal layer within the second peripheral area 122. The height of the portion of the metal layer within the central area 11 may be equal to the height of the portion of the metal layer within the control electrode connection area 13, and the height of the portion of the metal layer within the first peripheral area 121 may also be equal to the height of the portion of the metal layer within the second peripheral area 122. However, the present invention is not limited thereto. Different heights are also possible, but would result in increased process complexity. For example, a layer of metal material may be formed in the die mounting area of the substrate, the metal material in the first peripheral area 121 and the second peripheral area 122 is half-etched, and the metal material between the central area 11 and the control electrode connection area 13 is fully etched.

As shown in FIG. 5, a portion of the metal layer outside the die mounting area includes a source trace 14 and a gate trace 15. The source trace 14 and the gate trace 15 are insulated from each other. For example, as shown in FIG. 5, the source trace 14 and the gate trace 15 are spaced apart from each other by a gap G. The source trace 14 is connected to the portion of the metal layer within the first peripheral area 121, and the gate trace 15 is connected to the portion of the metal layer within the second peripheral area 122.

In an embodiment of the present invention, the substrate has a plurality of die mounting areas. As shown in FIG. 5, the gate trace 15 includes a first portion 151 and a second portion 152 parallel to each other, and a third portion 153 connecting the first portion 151 and the second portion 152. The first portion 151 and the second portion 152 are disposed on opposite sides of the plurality of die mounting areas. The source trace 14 is disposed in an area surrounded by the first portion 151, the second portion 152 and the third portion 153 of the gate trace 15.

In an embodiment of the present invention, the source trace 14 and the gate trace 15 have the same height as the portions of the metal layer within the central area 11 and the control electrode connection area 13. However, the present invention is not limited thereto, different heights are also possible, but would result in increased process complexity.

In an embodiment of the present invention, the plurality of die mounting areas includes a first group of die mounting areas and a second group of die mounting areas. The first group of die mounting areas and the second group of die mounting areas are arranged symmetrically. The first group of die mounting areas and the second group of die mounting areas each include multiple die mounting areas which are arranged in order along a straight line. The source trace 14 includes a connection portion 141 and an extension portion 142 that are connected together. The extension portion 142 of the source trace 14 extends between the first group of die mounting areas and the second group of die mounting areas to be connected to the metal layer in the first peripheral areas 121 of the first group of die mounting areas and the second group of die mounting areas. The connection portion 141 of the source trace 14 is located at one side of the plurality of die mounting areas for direct connection with the source contact. The first portion 151 and the second portion 152 of the gate trace 15 extend on opposite sides of the first group of die mounting areas and the second group of die mounting areas to be connected to the metal layer within the second peripheral areas 122 of the first group of die mounting areas and the second group of die mounting areas. FIG. 5 shows an example of 4 die mounting areas, but the present invention is not limited thereto, and the number of the die mounting areas may also be 2, 6, 8, and so on.

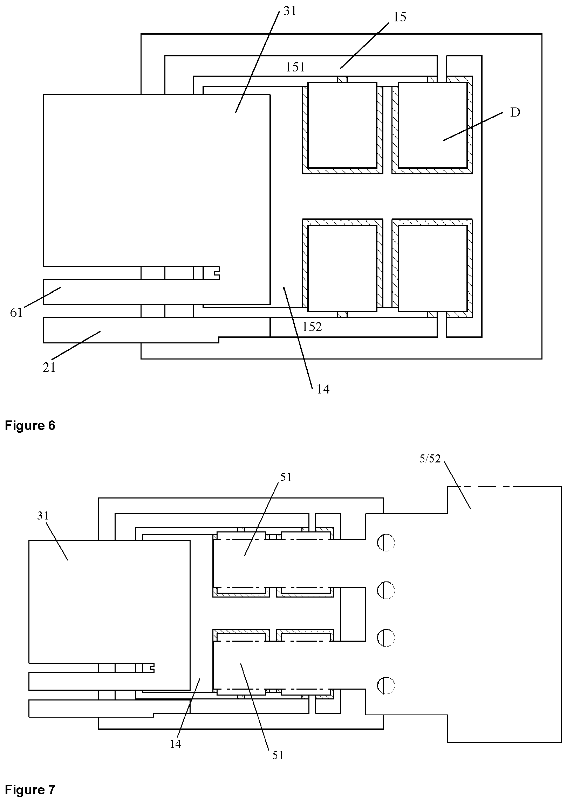

FIG. 6 is a schematic diagram illustrating that a semiconductor die, a source contact and a gate contact are attached to the substrate of FIG. 5. As shown in FIG. 6, the semiconductor die D is attached to the die mounting area of the substrate, with the source contact 31 being attached to the source trace 14, and the gate contact 21 being attached to the gate trace 15. Specifically, the source contact 31 is attached to the connection portion of the source trace 14, and the gate contact 21 is attached to the first portion 151 or the second portion 152 of the gate trace 15. The attachment may be realized by a metallic particle sintering method. The gate pad GP of the semiconductor die D (the gate pad GP is on the side of the semiconductor die facing the substrate, not shown in FIG. 6) is attached to the portion of the metal layer within the control electrode connection area 13 so as to be connected to the gate trace 15, and the source pad SP of the semiconductor die D (the source pad SP is on the side of the semiconductor die facing the substrate, not shown in FIG. 6) is attached to the portion of the metal layer within the central area 11 so as to be connected to the source trace 14. That is, the semiconductor die D is attached to the substrate in a "source down" configuration with the drain pad of the semiconductor die D facing away from the substrate.

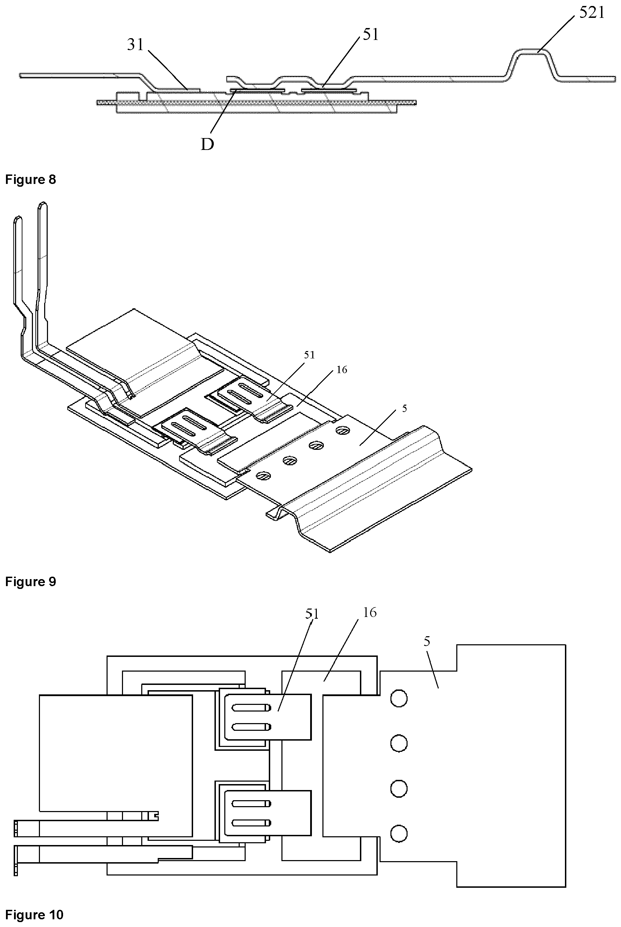

FIG. 7 is a top view of the power module package of FIG. 2, and FIG. 8 is a side view of the power module package of FIG. 2. As shown in FIGS. 2, 7 and 8, the drain contact 51 is attached to the drain pad DP of the semiconductor die D. For example, the drain contact 51 is attached to the drain pad DP of the semiconductor die D with a metallic particle sintering method.

In an embodiment of the present invention, as shown in FIG. 7, the power module package further includes a drain lead frame 5, the drain lead frame 5 includes a main body portion 52 and two drain contacts 51 extending from the main body portion 52. One of the two drain contacts 51 is attached to the drain pad of each semiconductor chip D disposed in the first group of die mounting areas, and the other drain contact 51 is attached to the drain pad DP of each semiconductor die D disposed in the second group of die mounting areas. As shown in FIG. 8, the main body portion 52 includes a stress relief structure 521.

In an embodiment of the present invention, the drain contact may cover the entire backside of the semiconductor die, or a portion of the backside of the semiconductor die. It could be understood that the larger the drain contact, the larger its contact area with the drain pad, and the better the heat dissipation. In the case where the drain contact may cover the entire backside of the semiconductor die, the drain contact may be attached to the entire surface of the drain pad DP. In this way, the entire surface of the drain pad DP is used to contact and connect with the drain contact, thereby improving the package resistance. In the case where the drain contact covers a portion of the semiconductor die, the size of the portion of the drain pad DP in contact with the drain contact may be at least 70% of the surface area of the drain pad DP, may be at least 80% of the surface area of the drain pad DP, may be at least 90% of the surface area of the drain pad DP, or may be at least 95% of the surface area of the drain pad DP.

As shown in FIGS. 2, 7 and 8, the source contact 31 and the drain contact 51 extend to two opposite directions, respectively. As shown in FIG. 7, the source contact 31 is connected to the source trace 14 and then extends to the left, and the drain contact 51 is connected to the drain pad DP and then extends to the right. In this way, the package resistance could be reduced, and a more uniform voltage distribution can be achieved in each semiconductor die.

In an embodiment of the present invention, as shown in FIGS. 2 and 6, the power module package further includes a Kelvin probe 61, and the Kelvin probe 61 is connected to the source contact 31 and attached to the source trace 14 on the substrate 1 together with the source contact 31. The Kelvin probe 61 will be described in more detail below.

In an embodiment of the present invention, the power module package is directly connected to an actively cooled heat sink (not shown in the figures). For example, the heat sink may be a liquid cooled heat sink, or any other heat sink suitable for use in this field. "Directly connected" herein means that the package surface (the exposed bottom surface of the substrate) is bonded to the heat sink by, for example, soldering or Ag sintering. The direct connection improves heat dissipation efficiency compared to a conventional cooling method in which the package is not directly connected to the heat sink but is in contact with the heat sink through thermal grease.

The power module according to the present invention is a multi-die high voltage (blocking voltage up to 1700V) power module with source down configuration and Kelvin source connection, and is capable of conducting high current of 100-320A. The Kelvin probe 61 connected to the source contact needs to monitor the forward voltage of the semiconductor die to optimize the module gate drive performance. The source down design eliminates the need for wire bond connection and improves the electrical heating performance.

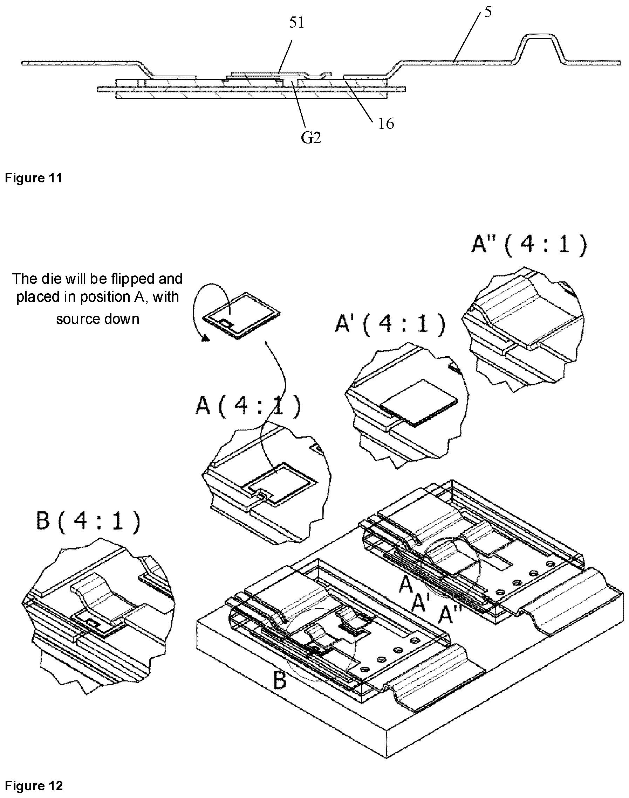

FIGS. 9 to 11 show where the power module package includes a drain contact and a drain lead frame separated from each other. In this embodiment, the power module package includes a drain contact 51 and a drain lead frame 5 separated from each other, and a drain trace 16 insulated from the abovementioned metal layer is also provided on the substrate. One end of the drain contact 51 is attached to the drain pad of the semiconductor die, while the other end of the drain contact 51 is attached to the drain trace 16. A separate drain lead frame 5 is attached to the drain trace 16 so as to be connected to the drain contact 51 via the drain trace 16, and in turn connected to the drain pad of the semiconductor die. As shown in FIG. 11, the drain trace 16 is spaced apart from the abovementioned metal layer by a gap G2.

FIG. 12 is a comparison diagram of a power module package according to the present invention and a source up power module package of the prior art. In FIG. 12, parts A, A' and A" show enlarged views of the circled portion of the power module package according to the present invention in different states. Part A shows a die mounting area in a state without a semiconductor die attached, part A' shows a state where the semiconductor die is attached to the die mounting area, and part A" shows a state where the drain contact is attached to the drain pad of the semiconductor die. Part B shows an enlarged view of the circled portion of the source up power module package of the prior art with a source contact attached. It can be seen by comparison that, the connection area (clip area) between the source contact and the source pad in the power module package of the prior art is significantly smaller than the connection area (clip area) between the drain contact and the drain pad in the power module package according to the present invention. In the source up case, the source contact may be thick aluminum wire or copper clip. Compared to thick aluminum wire, copper clip has improved electrical and thermal properties, so more and more silicon carbide packages employ copper clip contact. The copper clip has high hardness, and has a thermal expansion coefficient much greater than that of silicon carbide die. Larger contact surface between the copper clip and the source could reduce the reliability of the passivation layer around the source metal. Therefore, presently, the contact area between the copper clip and the silicon carbide source pad is designed to be relatively small. For example, the contact portion between the source pad and the source contact of the existing source up power module package is not higher than 30% of the area of the semiconductor die. Instead, in the source down case, the copper layer on the substrate, such as DBC, is relatively soft, and the thermal expansion coefficient of the ceramic inside the DBC is close to that of silicon carbide, which could reduce reliability risk and increase the contact area between the source pad and the copper layer on the DBC. Moreover, with source down and drain up, no passivation layer is provided on the drain side, and therefore the drain pad could be fully in contact with the copper clip (also known as drain clip).

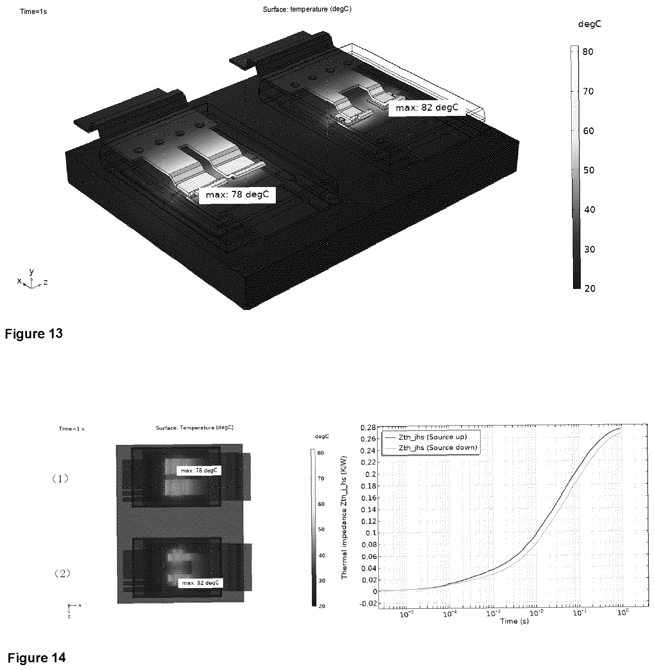

FIGS. 13, 14 and 15 show thermal performance comparison between source down connection and source up connection. It should be noted that it is very difficult to improve the thermal impedance of the source up configuration due to the excellent thermal conductivity of the substrate of SiC die. Experimentations have shown that as the connection area between the drain pad and the drain contact gradually increases, both the heat dissipation and the electrical performance also gradually increase.

FIG. 13 is a finite element steady state thermal simulation of a source up configuration (82 degrees Celsius) and a source down configuration (78 degrees Celsius) directly bonded to an actively cooled Al heat sink, with the bottom boundary maintained at room temperature (23 degrees Celsius). Each die consumes about 100W of power. The overall temperature of the source down configuration according to the present invention is a few degrees (4 degrees Celsius) lower than that of the source up configuration.

FIG. 14 is a finite element simulation for the thermal impedance calculation of the SiC junction temperature towards the backside of the heat sink. A source down design (part (1)) with a large drain clip was compared to an old design (part (2)) with a source up configuration and wire bonded gate connection. The thermal impedance curve of the source down configuration is lower, and therefore the heat dissipation effect of such design is better. Specifically, in the source up configuration, the temperature increased from 23 degrees to 82 degrees, whereas in the source down configuration, the temperature increased from 23 degrees to 72 degrees, which is a 6.8% reduction in the amplitude of the temperature rise compared to the source up configuration. For some severe use scenarios, the temperature of the silicon carbide die can be as high as 175 degrees, that is the temperature is increased from 23 degrees to 175 degrees, and if the temperature rise could be reduced by 6.8%, that is the temperature of the silicon carbide die is increased from 23 degrees to 165 degrees, the service life of the die would be greatly improved.

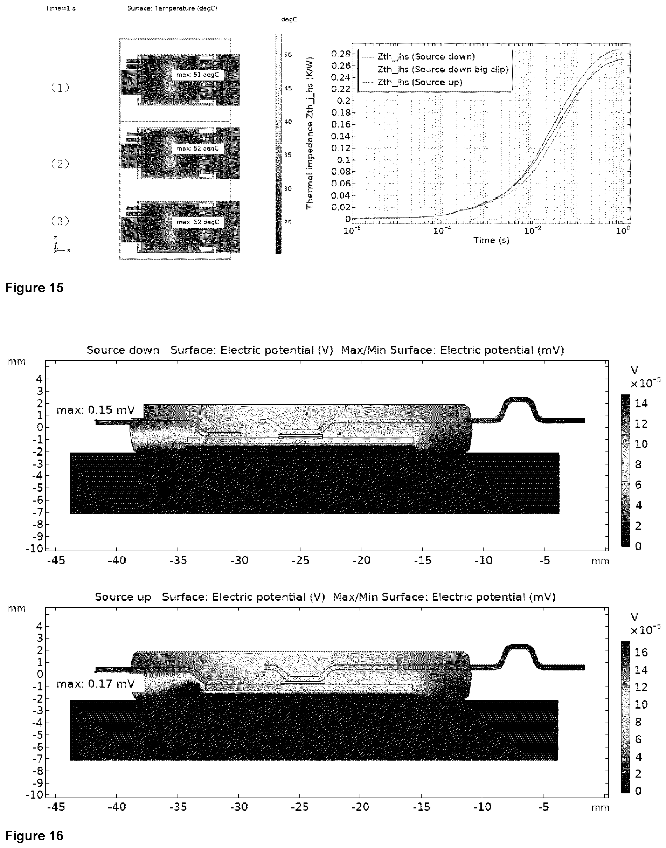

FIG. 15 is another finite element simulation for the thermal impedance calculation of the SiC junction temperature towards the backside of the heat sink. Part (1) in FIG. 15 shows a source down design with a large drain clip, part (2) shows a source down design with a small drain clip, and part (3) shows a source up design with a small drain clip. Simulation results show that the source down design performs better when bonded to a relatively larger drain clip.

FIG. 16 shows a finite element simulation of DC electrical performance. Both modules were subjected to the same current I=1[A], and the SiC die was modeled as a Cu conductor. The upper module corresponds to source down configuration, while the lower module corresponds to source up configuration. It can be seen from the simulation results that, the total voltage drop between the source and drain is lower in the source down configuration than in the source up configuration, which corresponds to a significantly reduced Rdson of the package. The source down configuration can conduct current of up to tens to hundreds of amperes.

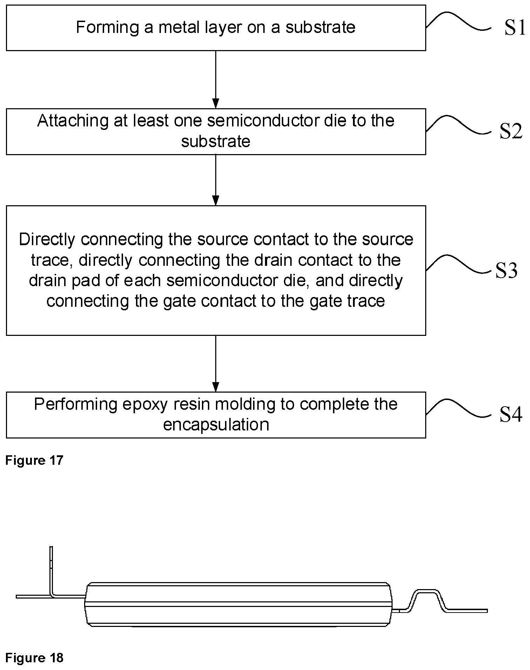

In another aspect, the present invention further provides a method of manufacturing a power module package. FIG. 17 is a flow chart of a method of manufacturing a power module package according to the present invention.

In step S1, a metal layer is formed on a substrate. For example, a metal material is first formed on the substrate, as shown in FIG. 5, and the metal material in the first peripheral area 121 and the second peripheral area 122 of the die mounting area is partially etched (e.g., half-etched). The metal material in the central area 11 of the die mounting area is not etched and remains in connection with the metal material in the first peripheral area 121, but has a height greater than that of the metal material in the first peripheral area 121. The metal material in the control electrode connection area 13 of the die mounting area is not etched and remains in connection with the metal material in the second peripheral area 122, but has a height greater than that of the metal material in the second peripheral area 122. In this way, die edge features may be formed in the first peripheral area 121 and the second peripheral area 122 of the die mounting area to facilitate the subsequent realization of fine gate connection and proper die edge clearance. Next, the metal material is fully etched to form a gap G between the source trace 14 and the gate trace 15, and a gap between the central area 11 and the control electrode connection area 13. The metal material in the first peripheral area 121 is connected to the source trace 14 and the metal material in the second peripheral area 122 is connected to the gate trace 15. In an embodiment of the present invention, the metal material may be Cu.

The source trace and the gate trace on the substrate and the metal layer in the die mounting area may have the abovementioned configurations, and will not be described in detail here.

It could be understood that the source trace and the gate trace on the substrate and the metal layer in the die mounting area may be formed by other means, and the current invention is not limited thereto.

In step S2, at least one semiconductor die is attached to the substrate. The source pad and the gate pad of each semiconductor die are located on a first surface of the semiconductor die, and the drain pad thereof is located on a second surface of the semiconductor die opposing the first surface.

In step S2, the attaching includes: causing the first surface of each semiconductor die to face the substrate, connecting the source pad to the source trace, and connecting the gate pad to the gate trace.

The semiconductor die may be placed with a flip chip bonder having high precision visual alignment to ensure alignment of the semiconductor die with the die mounting area of the substrate, specifically, alignment of the gate pad with the control electrode connection area and alignment of the source pad with the central area. A sintering process, a soldering process or DAF (Die attach film) may be used to attach the semiconductor die to the substrate, specifically, to attach the gate pad to the metal layer within the control electrode connection area, while attaching the source pad to the metal layer within the central area. Since the gate pad and the source pad are attached to the substrate in the same assembly step, the manufacturing complexity is reduced and the most accurate process steps could be utilized in die placement and attachment, thereby making subsequent drain connections easier because no more accurate positioning is required.

In step S3, the source contact is directly connected to the source trace, the drain contact is directly connected to the drain pad of each semiconductor die, and the gate contact is directly connected to the gate trace.

A clip process or a sintering, soldering process may be employed to attach the source contact to the source trace, attach the drain contact to the drain pad of the semiconductor die, and attach the gate contact to the gate trace to complete the interconnection. In some embodiments, the drain contact is attached to the drain pad by a metallic particle sintering (e.g., Ag sintering or Cu sintering) method with or without pressure. The sintering connection enhances the overall thermal conductivity and reliability of the power module package. Further, a Kelvin probe may be formed to be directly connected to the source contact.

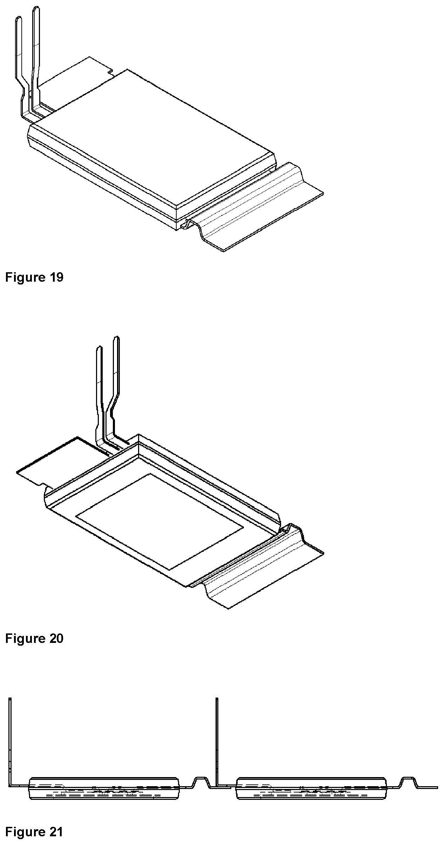

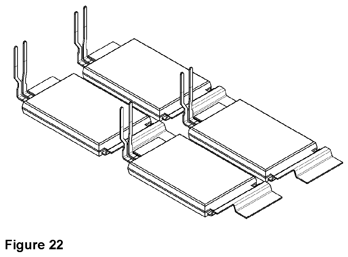

In step S4, epoxy resin molding is performed to complete the encapsulation. FIGS. 18 to 20 are perspective views seen from different angles after completion of the encapsulation. FIGS. 21 to 22 are schematic diagrams of multiple packages interconnected. Multiple packages can be connected to each other by soldering.

The power module package according to the present invention may be applied to an automotive powertrain inverter, a solar inverter, a wind inverter, an on-board charger (OBC) for an electric automobile, and the like, and generally employs a three-phase half-bridge configuration.

Finally, it should be noted that the above embodiments are only used to illustrate, rather than limit, the technical solutions of the present invention. Although the present invention has been described in detail with reference to the above embodiments, a person of ordinary skill in the art should understand that: the technical solutions recited in the above embodiments could be modified, or some or all of the technical features thereof could have equivalent substitutions, for example, the features of the dependent claims could be freely replaced and/or combined as required, and these modifications or substitutions do not essentially make the corresponding technical solutions depart from the scope of the technical solutions of the embodiments in the present invention.

### List of reference numerals:

| Component | Reference numeral |
|---|---|
| 1 | Substrate |
| 2 | Wire |
| 3 | Source lead frame |
| 4 | Metal layer |

| | |
|---|---|
| 5 | Drain lead frame |
| D | Semiconductor die |
| SP | Source pad |
| GP | Gate pad |
| DP | Drain pad |
| DA | Die mounting area |
| 10 | Metal layer |
| 11 | Central area |
| 121 | First peripheral area |
| 122 | Second peripheral area |
| 13 | Control electrode connection area |
| 14 | Source trace |
| 141 | Connection portion |
| 142 | Extension portion |
| 15 | Gate trace |
| 151 | First portion |
| 152 | Second portion |
| 153 | Third portion |
| 17 | Stud bump |
| G | Gap |
| 21 | Gate contact |

| | |
|---|---|
| 31 | Source contact |
| 51 | Drain contact |
| 52 | Main body portion |
| 521 | Stress relief structure |
| 61 | Kelvin probe |
| 16 | Drain trace |

## Claims

1. A power module package, comprising:
a substrate,
a first trace and a second trace on the substrate, the first trace and the second trace being insulated from each other,
at least one semiconductor die, each of the at least one semiconductor die comprising a first electrode pad, a second electrode pad, and a control electrode pad, wherein the first electrode pad and the control electrode pad are on a first surface of the semiconductor die, the first surface facing the substrate, the second electrode pad is on a second surface of the semiconductor die, the second surface facing away from the substrate, the first electrode pad is connected to the first trace, and the control electrode pad is connected to the second trace,
a first electrode contact directly connected to the first trace,
a second electrode contact directly connected to the second electrode pad of each semiconductor die from a side of the at least one semiconductor die away from the substrate, and
a control electrode contact directly connected to the second trace.

2. The power module package of claim 1, wherein an entire surface of the second electrode pad is directly connected to the second electrode contact.

3. The power module package of claim 1, wherein the power module package has a die mounting area, and the power module package comprises a metal layer on the substrate within the die mounting area,
the die mounting area comprises a central area, a control electrode connection area, a first peripheral area surrounding the central area, and a second peripheral area surrounding the control electrode connection area, the metal layer within the control electrode connection area is insulated from the metal layer within the central area, the metal layer within the central area and the metal layer within the first peripheral area are connected and have different heights, and the metal layer within the control electrode connection area and the metal layer within the second peripheral area are connected and have different heights.

4. The power module package of claim 3, wherein the first electrode pad is attached to the metal layer within the central area by a metallic particle sintering method, and the second electrode contact is attached to the second electrode pad by a metallic particle sintering method.

5. The power module package of claim 3, wherein the first trace, the second trace and the metal layer are formed from a same layer of metal, and
the first trace and the second trace have a same height as the metal layer within the central area.

6. The power module package of claim 3, wherein the substrate has a plurality of die mounting areas,
the second trace comprises a first portion and a second portion parallel to each other, and a third portion connecting the first portion and the second portion, the first portion and the second portion are disposed on opposite sides of the plurality of die mounting areas and connected to the control electrode pads of the dies in the die mounting areas, and
the first trace is disposed within an area surrounded by the second trace and connected to the first electrode pads of the dies in the plurality of die mounting areas.

7. The power module package of claim 6, wherein the plurality of die mounting areas comprises a first group of die mounting areas and a second group of die mounting areas, the first group of die mounting areas and the second group of die mounting areas are arranged symmetrically, and the first trace extends between the first group of die mounting areas and the second group of die mounting areas.

8. The power module package of claim 7, further comprising a lead frame comprising a main body portion and two second contacts extending from the main body portion,
wherein the second electrode pads of the semiconductor dies disposed in the first group of die mounting areas are directly connected to one of the two second contacts, and the second electrode pads of the semiconductor dies disposed in the second group of die mounting areas are directly connected to the other of the two second contacts.

9. The power module package of claim 8, wherein the main body portion comprises a stress relief structure.

10. The power module package of claim 1, further comprising a Kelvin probe directly connected to the first electrode contact.

11. The power module package of claim 1, wherein the first electrode contact and the second electrode contact extend toward two opposite directions, respectively.

12. The power module package of claim 1, wherein the control electrode pad comprises gold stud bump or copper stud bump.

13. The power module package of claim 1, wherein the first electrode pad is a source pad, the second electrode pad is a drain pad, and the control electrode pad is a gate pad, or
the first electrode pad is an emitter pad, the second electrode pad is a collector pad, and the control electrode pad is a gate pad.

14. A method of manufacturing a power module package, comprising:
forming a first trace and a second trace insulated from each other on a substrate,
attaching at least one semiconductor die to the substrate, wherein each of the at least one semiconductor die comprises a first electrode pad, a second electrode pad and a control electrode pad, the first electrode pad and the control electrode pad are on a first surface of the semiconductor die, the second electrode pad is on a second surface of the semiconductor die opposite to the first surface, and the attaching comprises:
causing the first surface of each semiconductor die to face the substrate, and
connecting the first electrode pad to the first trace, and connecting the control electrode pad to the second trace,
directly connecting a first electrode contact to the first trace, directly connecting a second electrode contact to the second electrode pad of each semiconductor die, and directly connecting a control electrode contact to the second trace.

15. The method of claim 14, wherein the power module package has a die mounting area comprising a central area, a control electrode connection area, a first peripheral area surrounding the central area, and a second peripheral area surrounding the control electrode connection area, and the method further comprises:
forming a metal layer within the die mounting area, such that the metal layer within the control electrode connection area is insulated from the metal layer within the central area, the metal layer within the central area and the metal layer within the first peripheral area are connected and have different heights, the metal layer within the control electrode connection area and the metal layer within the second peripheral area are connected and have different heights, the metal layer within the first peripheral area is connected to the first trace, and the metal layer within the second peripheral area is connected to the second trace.

16. The method of claim 15, wherein the attaching further comprises:
aligning the control electrode pad with the control electrode connection area, and aligning the first electrode pad with the central area, and
attaching the control electrode pad to the metal layer within the control electrode connection area, while attaching the first electrode pad to the metal layer within the central area.

17. The method of claim 16, wherein the aligning and attaching are implemented by a flip chip bonder with high precision visual alignment.

18. The method of claim 15, wherein the first trace, the second trace and the metal layer are formed by etching a same metal material layer on the substrate, and
the first trace and the second trace have a same height as the metal layer within the central area.
